# EUROPEAN PATENT SPECIFICATION

(11) **EP 3 994 104 B1**
(45) Date of publication and mention of the grant of the patent: **09.10.2024**
(21) Application number: 20740258.7
(22) Date of filing: 06.07.2020
(51) Int. Cl.: C09K 9/00, C03C 17/22, C23C 14/06, C23C 14/58, G02B 5/23

(54) **METHOD FOR PRODUCING AN OXYHYDRIDE-BASED PHOTOCHROMIC DEVICE**
VERFAHREN ZUR HERSTELLUNG EINER FOTOCHROMEN VORRICHTUNG AUF OXYHYDRIDBASIS
PROCÉDÉ DE PRODUCTION D'UN DISPOSITIF PHOTOCHROMIQUE À BASE D'OXYHYDRURE

(30) Priority: 05.07.2019 NO 20190855
(43) Date of publication of application: 11.05.2022
(73) Proprietor: Institutt for Energiteknikk, 2027 Kjeller (NO)
(72) Inventor: BABA, Elbruz Murat, 0175 Oslo (NO); KARAZHANOV, Smagul, 1061 Oslo (NO)
(74) Representative: Dehns
(86) International application number: PCT/EP2020/068991
(87) International publication number: WO 2021/005003

(56) References cited:
- EP-A1- 3 435 151
- WO-A1-2017/125573
- WO-A1-2018/024394
- BABA E M ET AL: "Light-induced breathing in photochromic yttrium oxy-hydrides", ARXIV.ORG, CORNELL UNIVERSITY LIBRARY, 201 OLIN LIBRARY CORNELL UNIVERSITY ITHACA, NY 14853, 12 March 2019 (2019-03-12), XP081132703
- NAFEZAREFI F ET AL: "Photochromism of rare-earth metal-oxy-hydrides", APPLIED PHYSICS LETTERS, A I P PUBLISHING LLC, US, vol. 111, no. 10, 8 September 2017 (2017-09-08), XP012221902, ISSN: 0003-6951, [retrieved on 20170908], DOI: 10.1063/1.4995081
- DATABASE WPI Week 201919, 28 December 2018 Derwent World Patents Index; AN 2019-02421B, XP002800665

## Description

Due to improved building techniques and the utilization of modern methods for the fabrication of glass, large windows are an increasingly common sight in modern architecture. Although the incorporation of large-area windows often results in aesthetic facades and excellent indoor lighting conditions, it can also represent a challenge in terms of energy efficiency and energy savings. Windows are, from an insulating point of view, the weakest point in a building, mainly because of their poor thermal insulation properties, but also because they allow for a significant unwanted indoors-outdoors radiative heat exchange.

Smart windows industry is currently dominated by technologies which give relative control, for example by utilizing electricity or dispersed particle alignment methods. However, this control itself creates a pseudo sensation of "smart" technology because an authentic smart technology requires no control and adjust itself with the specifications it was designed according to the environment it resides. On the other hand, one promising application can be considered as smart; photochromic applications. They can adjust themselves to the environmental change without needing any control and have relatively simple structural designs compared to the complex electrochromic applications. Therefore, photochromic applications show high promise at the current industry as a genuine smart technology for future applications.

Previously, photochromic oxygen containing Yttrium hydride films, e.g. production was demonstrated in the articles by T. Mongstad et al., Solar Energy materials and Solar Cells 95 (2011) 3596-3599, "A new thin film photochromic material: Oxygen-containing yttrium hydride" and, C.C. You, Applied Physics Letters 105, 031910 (2014), "Engineering of the band gap and optical properties of thin films of yttrium hydride" and in international patent applications WO2017/125573 (IFE), WO2018/024394 (IFE) and WO2016/109651 (Saint Gobain).

The fabrication method according to the invention relates to the production method described in WO2018/024394 where oxyhydride coatings are produced as follows: an initial reactive sputter deposition of a metal hydride thin film based on a rare earth, lanthanide or alkaline metal-potentially doped by one or more other elements from the same groups, followed by a subsequent oxidation in air that aims to generate or improve any photochromic properties within the material. However, oxyhydride material tends to degrade when exposed to air or with prolonged illumination as also mentioned in WO2017/125573. Although it was postulated in the same publication that oxygen itself is the reason for increased stress levels, cracking/deformation and delamination of the material, there is no result supporting the postulate. Here we describe an improved working environment and storage conditions for oxyhydride materials.

The problems discussed above are solved using the method as described in the accompanying claims.

More specifically the present invention thus concerns a method of producing a rare earth metal oxyhydride-based photochromic device, and more specifically relates to a method of preparation, storing and working conditions for a rare earth metal oxyhydride-based (REMOH) photochromic device comprising a substrate, at least one layer including a photochromic layer having a chosen band gap range where the REMOH-based device preparation method comprises the steps of: -first the formation on a substrate of a layer of rare-earth metal hydride with a predetermined thickness using a physical vapor deposition process; and -second oxidizing the films. Distinction from the above-mentioned publications in the present patent is about finding the way to prevent degradation of the photochromic material over time and preserving photochromic kinetics. This is related to avoiding water levels that would damage the device but preserving some water levels for necessary for maintaining the photochromic kinetics, specifically bleaching (recovery when illumination stops or intensity reduces or light source wavelength composition changes), that would occur in an essentially water (water, humidity or vapour etc.) free environment. After the oxidation of the resulting rare-earth metal hydride material would be a REMOH with photochromic properties.

The invention will be described more in detail with reference to the accompanying drawings, illustrating the reason of the improvement to the device described above:
- Figure 1a-c: Illustrates the production method according to the invention.
- Figure 2a-e: Illustrates photochromic oxyhydride material optical kinetic degradation after stored at varying relative humidity levels.
- Figure 3: Illustrates microstructure deformation, caused by varying relative humidity levels.
- Figure 4a,b: Illustrates the photochromic kinetic difference between dry air (H2O<0.1 ppm) environment and ambient air environment.

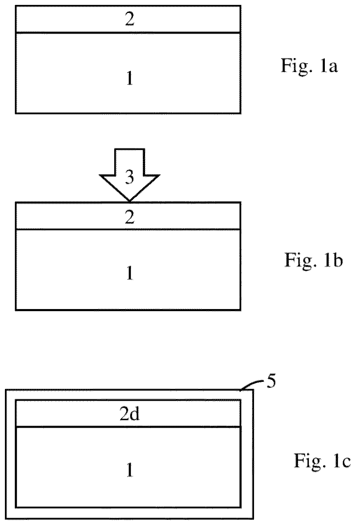

Figure 1a-c illustrates the production method according to the invention where the process with the deposition of an essentially oxygen-free metal hydride 2, preferably less than 0.1 ppm O₂, onto a substrate 1 (e.g. glass or a polymer-based substrate) as in figure 1a. The substrate is transparent where the aim of the photochromic layer is to provide a variable transmission rate depending on the light intensity. Transparent in this case also including a degree of attenuation, e.g. for permanent shading. The performance of the step of applying the metal hydride in the oxygen-free environment is known to the person skilled in the art, e.g. as discussed in WO2018/024394. The metal hydride may comprise a metal from the groups of rare earth elements, but according to the preferred embodiment of the invention the metal is yttrium, forming yttrium hydride.

In figure 1b the rare-earth metal hydride is exposed to an environment 3 that oxidizes the metal hydride, preferably in an environment where humidity present, forming rare-earth metal oxyhydride. Humidity in this case referring to any one of water vapour, liquid water in air or liquid water, as it is the chemical response with the water molecules that initiates the reaction. The oxidising environment should contain water in any form with a range of: water amount in air at sea level pressure with RH between >0%RH and 60%RH, for temperatures between 0°C and 40°C, preferably 25° Celsius.

In figure 1c the substrate 1 and the resulting oxyhydride is enclosed in a container 5 or similar keeping the relative humidity around the photochromic material at a low level which would contain less water in any form than the air at sea level pressure with 10% RH at 25° Celsius and above than 0.1 ppm H₂O.

According to the present invention the exposure to humidity is therefore limited afterward production so as to maintain the photochromic characteristics of the material.

The final oxygen content of the active photochromic film can be pre-defined by controlling properties like porosity and microstructure, thickness and other features of the as-deposited metal hydride as discussed in the publications mentioned above. These properties, as described below, can be achieved by tuning the deposition parameters, such as substrate temperature, substrate type, chamber pressure, sputtering power, deposition time, deposition gas flow, etc.

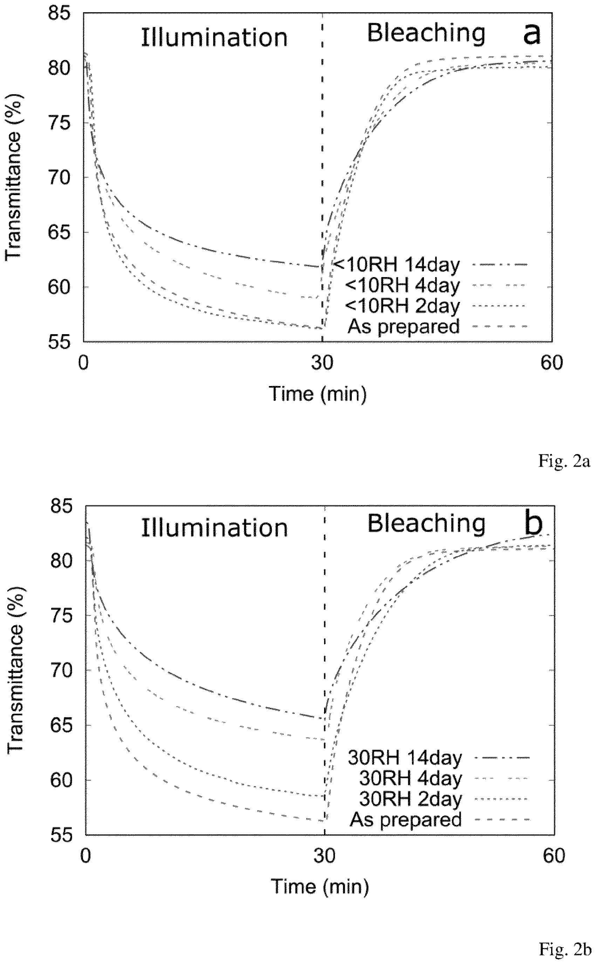

As mentioned above rare-earth metal oxyhydride materials, particularly yttrium oxyhydrides, are highly susceptible to environment. After oxidation at the end of the production process environmental elements, specifically water content in the air, cause cracking of the films, delamination, reducing the contrast, and damaging the photochromic kinetics. To illustrate this, we refer to the accompanying graphs in figure 2a-2e, an experimental procedure was designed using yttrium oxyhydride thin film coatings which were prepared according to the T. Mongstad (2011), C.C. You (2014) articles and WO2017/125573, then immediately after oxidation on air, placed in airtight boxes filled with regular air but with varying relative humidity at 25°C temperature. Figures 2a-e demonstrate photochromic kinetics of stored samples in relative humidity (RH) from <10%RH to 100%RH, respectively. Photochromic kinetic studies were performed with 30 minutes of illumination using an UV Laser and 30 minutes of storing at dark for recovery (bleaching). Kinetic studies were performed after 2, 4 and 14 days storing inside the airtight boxes with respective relative humidity.

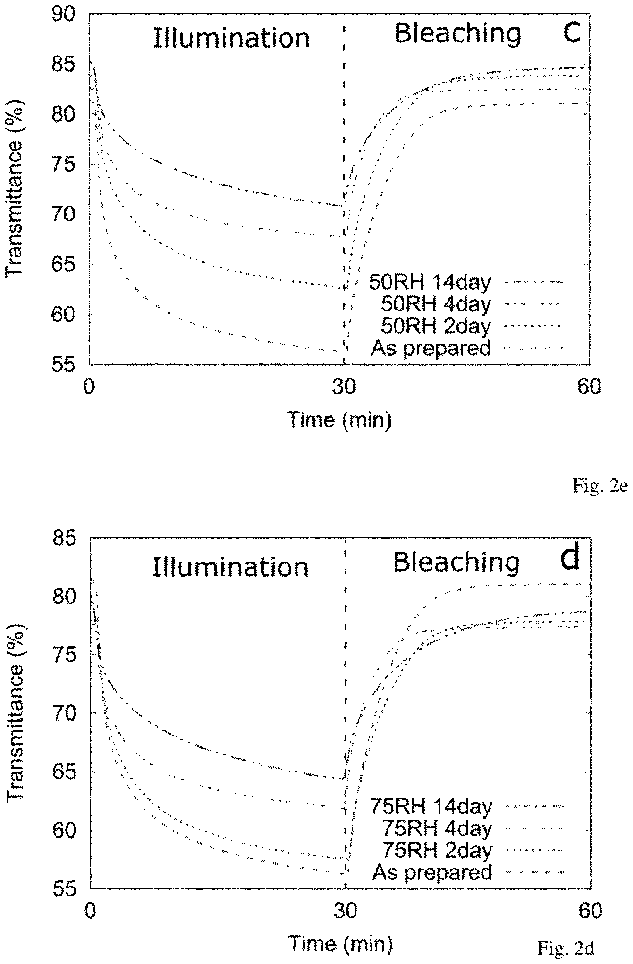

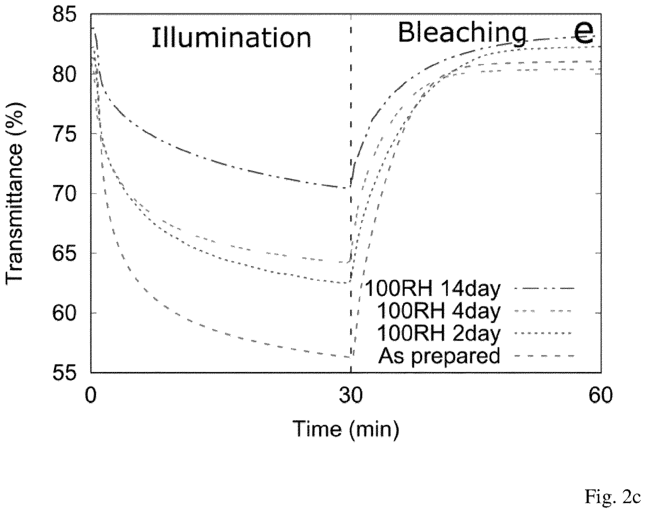

Photochromic yttrium oxyhydride coatings, initially, showing 25% contrast however, every sample demonstrates lower contrast with increased contrast loss depending on storage time (Figure 2 (a-e)). Contrast loss is strongly dependent on storage time but also water content level in the air is a factor for the speed of contrast loss. This can be observed, from Figures 2a-2e where contrast loss is more notable for samples stored at 100% RH after 14 days than at <10% RH and, samples stored at 100% RH lost the same contrast under 4days as the samples stored at <10% RH but after 14 days.

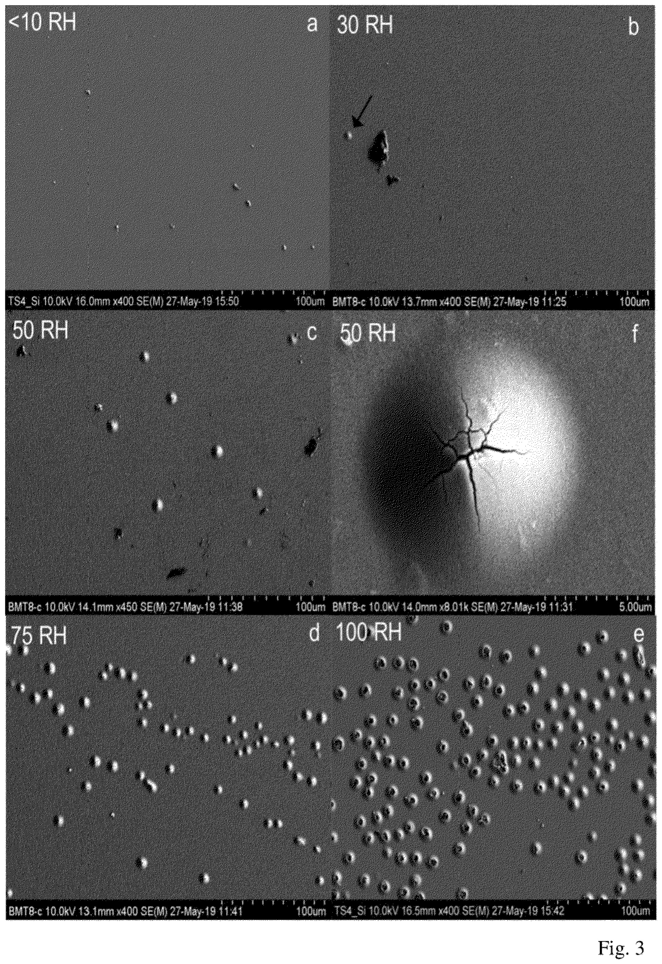

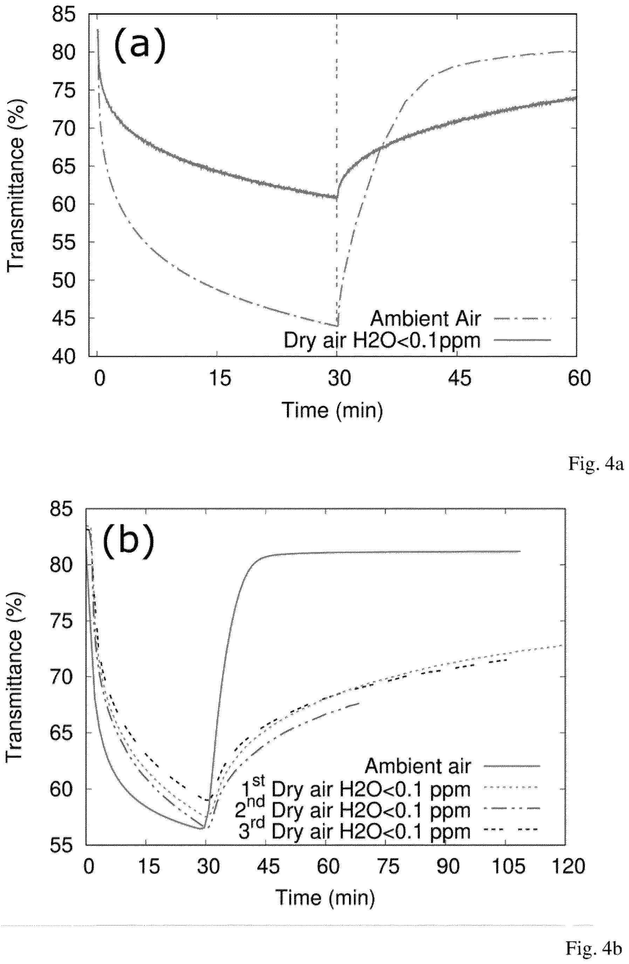

Figure 3 Scanning electron microscopy (SEM) images of microstructure deformation, caused by varying relative humidity levels; <10% (a), 30% (b), 50% (c), 75% (d) and 100% (e) after 14 days storage at room temperature. Panel (f) showing one deformation in detail. As can be seen structural change depending on the water content level in the air after 14 days of storage. Parallel to the increasing water content in air, increasing number of cracks and deformation can be observed which is correlated with contrast loss of photochromic oxyhydride material. On the other hand, absence of moisture as how conventional insulating glass units on buildings being prepared, has negative impact on the material's photochromic kinetics. In Figure 4(a,b), photochromic kinetics of yttrium oxyhydride in dry air environment (H₂O<0.1ppm) and ambient air environment can be observed. Bleaching speed of yttrium oxyhydride slowed considerably as a result of reduced oxidation agent presence, namely water content in air.

Due to the kinetic loss and structural deformation under air with higher water content than the water content of air with 10%RH at 25°C, storage and working environment of oxyhydride materials should therefore contain less water than the water content of air with 10%RH at 25°C water. Additionally, due to the kinetic loss under dry air environment with water content of H₂O<0.1 ppm, storage and working environment of oxyhydride materials should therefore contain water; H₂O≥0.1 ppm. Therefore, the produced material is preferably enclosed in a container after production having the described humidity in the contained environment.

As will also be understood by the person skilled in the art a small change of humidity and temperature would have the same water content but technically different humidity. Thus a water content of air with same volume at sea level pressure that is 25°C and 10%RH may correspond to 5%RH at 30°C more or less equal as higher temperature can hold more water and this humidity is Relative Humidity to the same water content to this defined limit. Therefore, under some circumstances the water content corresponding to 20% at sea level pressure and is 25°C depending on the intended use of the component, for example with varying temperaures.

To summarize the present invention relates to a method for producing a photochromic rare-earth metal oxyhydride material comprising the steps of formation on a substrate of a layer of an essentially oxygen free rare-earth metal hydride with a predetermined thickness preferably within the range of 50-1500 nm using a physical vapor deposition process. The substrate will preferably be a transparent substrate, e.g. a glass or polymer-based substrate. Following this the rare-earth metal hydride layer is exposed to air in a second step, where the metal hydride oxidises, by oxygen and water (humidity, vapour and/or moisture). The second step is performed in an environment which contain water in any form with a range of: water amount in air at sea level pressure with RH between >0% and 60%, for temperatures between 0°C and 40°C, preferably 25° Celsius

The metal hydride is chosen from the groups of rare earth metals, and according to the preferred embodiment of the invention an yttrium hydride.

In order to maintain the characteristics of the photochromic material the second step may be followed by a step of containing the material in a tight container or covering the photochromic material in a humidity/water tight material, sealing it from the environment. The rare-earth metal hydride may have a porosity being above zero, i.e. it contains hollow pores, voids and/or cavities to improve the absorption of oxygen in the oxyhydride.

A photochromic component is provided comprising a first, transparent substrate and a layer constituted metal oxyhydride enclosed in a humidity/water tight enclosure, where the oxyhydride is made from a rare-earth metal oxyhydride, preferably an yttrium oxyhydride, which can be made using the method described above. The environment in the container comprise water content in any form, equal or less than the water content of air at sea level pressure with 20%RH at 25°C, preferably 10%RH and above 0.1 ppm H₂O..

## Claims

1. Method for producing a photochromic rare-earth metal oxyhydride material comprising the steps of:
- first, in an environment with less than 0.1 ppm O₂, formation on a substrate of a layer of an essentially oxygen free rare-earth metal hydride with a predetermined thickness using a physical vapor deposition process;
and
- second, exposing the rare-earth metal hydride layer to an oxygen containing environment where the layer oxidizes and results with rare-earth metal oxyhydride, said second step being performed in an environment having water content in any form with a range defined by a water amount in air at sea level pressure with RH between >0% and 60% RH for temperatures between 0°C and 40°C.

2. Method according to claim 1, wherein the metal in the metal hydride is yttrium.

3. Method according to claim 1, wherein the thickness of the formed rare earth metal hydride layer is within the range of 50-1500 nm using a physical vapor deposition process

4. Method according to any of the preceding claims, followed by the step of oxidizing the material in a humidity tight container.

5. Method according to any of the preceding claims, followed by the step of containing or covering the oxyhydride material in a humidity/watertight material maintaining a humidity/water content in the container at a level less than air at sea level pressure with 10%RH at 25°C and the oxyhydride material having a water content H₂O≥0.1 ppm..

6. Method according to claim 1, wherein said metal hydride is fabricated on a transparent, e.g. on top of a glass or polymer-based substrate.

7. Method according to claim 1, wherein said water content as defined in step 2 is less than 60%RH at a temperature of 25° Celsius.

## Patentansprüche

1. Verfahren zur Herstellung eines photochromen Seltenerdmetalloxyhydrid-Materials, umfassend Folgende Schritte:
- erstens, in einer Umgebung mit weniger als 0,1 ppm O₂, Bildung einer Schicht aus einem im Wesentlichen sauerstofffreien Seltenerdmetallhydrid mit einer vorbestimmten Dicke auf einem Substrat unter Verwendung eines physikalischen Aufdampfungsprozesses;
und
- zweitens, Aussetzen der Seltenerdmetallhydridschicht einer sauerstoffhaltigen Umgebung, in der die Schicht oxidiert und Seltenerdmetalloxyhydrid resultiert, wobei der zweite Schritt in einer Umgebung durchgeführt wird, die Wassergehalt in beliebiger Form aufweist, mit einem Bereich, der durch eine Wassermenge in Luft bei Meereshöhendruck mit einer relativen Luftfeuchtigkeit zwischen >0 % und 60 % relative Luftfeuchtigkeit bei Temperaturen zwischen 0°C und 40°C definiert ist.

2. Verfahren nach Anspruch 1, wobei das Metall im Metallhydrid Yttrium ist.

3. Verfahren nach Anspruch 1, wobei die Dicke der gebildeten Seltenerdmetallhydridschicht im Bereich von 50-1500 nm liegt, wobei ein physikalisches Aufdampfungsverfahren verwendet wird.

4. Verfahren nach einem der vorstehenden Ansprüche, gefolgt vom Schritt des Oxidierens des Materials in einem feuchtigkeitsdichten Behälter.

5. Verfahren nach einem der vorstehenden Ansprüche, gefolgt vom Schritt des Einschließens oder Bedeckens des Oxyhydridmaterials in einem feuchtigkeits-/wasserdichten Material, das einen Feuchtigkeits-/Wassergehalt im Behälter auf einem niedrigeren Niveau als Luft auf Meereshöhendruck mit 10% relativer Luftfeuchtigkeit bei 25°C aufrechterhält, und wobei das Oxyhydridmaterial einen Wassergehalt von H₂O≥0,1 ppm aufweist.

6. Verfahren nach Anspruch 1, wobei das Metallhydrid auf einer transparenten Substrat, beispielsweise auf Glas- oder Polymerbasis hergestellt wird.

7. Verfahren nach Anspruch 1, wobei der in Schritt 2 definierte Wassergehalt weniger ist als 60% relative Luftfeuchtigkeit bei einer Temperatur von 25° Celsius.

## Revendications

1. Procédé de production d'un matériau photochromique à base d'oxyhydrure de métal de terre rare comprenant les étapes de :
- premièrement, dans un environnement contenant moins de 0,1 ppm d'O₂, formation sur un substrat d'une couche d'un hydrure de métal de terre rare sensiblement exempt d'oxygène présentant une épaisseur prédéterminée en utilisant un processus de dépôt physique en phase vapeur ;
et
- deuxièmement, exposition de la couche d'hydrure de métal de terre rare à un environnement contenant de l'oxygène où la couche s'oxyde et produit de l'oxyhydrure de métal de terre rare, ladite seconde étape étant réalisée dans un environnement présentant une teneur en eau sous n'importe quelle forme avec une plage définie par une quantité d'eau à la pression atmosphérique au niveau de la mer avec une HR comprise entre >0 % et 60 % HR pour des températures comprises entre 0 °C et 40° C.

2. Procédé selon la revendication 1, dans lequel le métal dans l'hydrure de métal est l'yttrium.

3. Procédé selon la revendication 1, dans lequel l'épaisseur de la couche d'hydrure de métal de terre rare formée est comprise dans la plage de 50-1500 nm en utilisant un processus de dépôt physique en phase vapeur.

4. Procédé selon l'une quelconque des revendications précédentes, suivi de l'étape d'oxydation du matériau dans un récipient étanche à l'humidité.

5. Procédé selon l'une quelconque des revendications précédentes, suivi de l'étape consistant à contenir ou à recouvrir le matériau oxyhydrure dans un matériau étanche à l'humdidité/l'eau maintenant une teneur en humidité/eau du récipient à un niveau inférieur à la pression atmosphérique au niveau de la mer avec 10 % HR à 25 °C et le matériau oxyhydrure présentant une teneur en eau H₂O ≥ 0,1 ppm.

6. Procédé selon la revendication 1, dans lequel ledit hydrure de métal est fabriqué sur un substrat transparent, par exemple sur le dessus d'un substrat à base de verre ou de polymère.

7. Procédé selon la revendication 1, dans lequel ladite teneur en eau telle que définie à l'étape 2 est inférieure à 60 % HR à une température de 25 ° Celsius.
